# EUROPEAN PATENT APPLICATION

(11) **EP 3 780 320 A1**
(43) Date of publication of application: **17.02.2021**
(21) Application number: 19822067.5
(22) Date of filing: 06.06.2019
(51) Int. Cl.: H02J 7/00

(54) **QUICK CHARGING METHOD FOR BATTERY, CHARGING APPARATUS, DEVICE TO BE CHARGED, AND CHARGING SYSTEM**

(30) Priority: 18.06.2018 CN 201810625760
(71) Applicant: GUANGDONG OPPO MOBILE TELECOMMUNICATIONS CORP., LTD., Dongguan Guangdong 523860 (CN)
(72) Inventor: CHEN, Wei, Dongguan, Guangdong 523860 (CN)
(74) Representative: Mewburn Ellis LLP
(86) International application number: PCT/CN2019/090244
(87) International publication number: WO 2019/242504

(57) **Abstract**

A method for quick charging of a battery, a charging apparatus, a device to-be-charged, and a charging system are provided. The method includes the following. Constant-current charging is performed on at least one battery at a first charging rate until a voltage across any one of the at least one battery reaches a first voltage, where the first voltage is higher than a minimum rated voltage in rated voltages of the at least one battery. Constant-voltage charging is performed on the at least one battery. A current of each of the at least one battery is acquired, and for any one of the at least one battery, charging of the battery is stopped when a current of the battery reaches a corresponding preset threshold current. As such, a voltage across each of the at least one battery can exceed the rated voltage through charging, and thus charging can be performed beyond limitation of rated parameters of the battery, which can significantly shorten charging time and increase charging speed without adversely affecting service life of the battery.

## Description

### CROSS-REFERENCE TO RELATED APPLICATION(S)

This application claims priority to and the benefit of Chinese Application Patent Serial No. 201810625760.X filed on June 18, 2018, the entire disclosure of which is hereby incorporated by reference.

### TECHNICAL FIELD

This disclosure relates to the field of charging, and more particularly to a method for quick charging of a battery, a charging apparatus, a device to-be-charged, and a charging system.

### BACKGROUND

In the related art, in order to increase charging speed, a charging scheme is generally optimized as much as possible within a rated parameter of a battery, for example, in a step-like charging manner. However, due to limitation of rated voltage and rated current, if the step-like charging manner is adopted, it is impossible to achieve a significant increase in charging speed.

### SUMMARY

The disclosure aims at solving at least to some extent one of the technical problems in the related art.

Therefore, a first purpose is to provide a method for quick charging of a battery, which is possible to charge the battery beyond limitation of rated parameters of the battery, thereby increasing charging speed.

A second purpose is to provide a charging apparatus.

A third purpose is to provide a device to-be-charged.

A fourth purpose is to provide a charging system.

A fifth purpose is to provide a non-transitory computer-readable storage medium.

A sixth purpose is to provide a method for quick charging of a battery.

A seventh purpose is to provide a charging apparatus.

An eighth purpose is to provide a device to-be-charged.

A ninth purpose is to provide a charging system.

A tenth purpose is to provide a non-transitory computer-readable storage medium.

To achieve the above purposes, in a first aspect, a method for quick charging of a battery is provided. The method includes the following. Constant-current charging is performed on at least one battery at a first charging rate until a voltage across any one of the at least one battery reaches a first voltage, where the first voltage is higher than a minimum rated voltage in rated voltages of the at least one battery. Constant-voltage charging is performed on the at least one battery. A current of each of the at least one battery is acquired, and for any one of the at least one battery, charging of the battery is stopped when a current of the battery reaches a corresponding preset threshold current.

According to the method provided herein, constant-current charging is performed on the at least one battery at the first charging rate until the voltage across any one of the at least one battery reaches the first voltage. Then constant-voltage charging is performed on the at least one battery until the current of each of the at least one battery reaches the corresponding preset threshold current. In this way, a voltage across each of the at least one battery can reach a voltage that is higher than the rated voltage through charging, and thus charging can be performed beyond limitation of rated parameters of the battery, which can significantly shorten charging time and increase charging speed without adversely affecting service life of the battery.

To achieve the above purposes, in a second aspect, a charging apparatus is provided. The charging apparatus is configured to communicate with a device to-be-charged when coupled with the device to-be-charged via a charging interface. The charging apparatus includes a first communication control circuit and a first charging circuit. The first communication control circuit is configured to operate as follows. The first communication control circuit is configured to perform, via the first charging circuit, constant-current charging on at least one battery at a first charging rate until a voltage across any one of the at least one battery reaches a first voltage, and acquire, via the device to-be-charged, a voltage across each of the at least one battery, where the first voltage is higher than a minimum rated voltage in rated voltages of the at least one battery. The first communication control circuit is configured to perform, via the first charging circuit, constant-voltage charging on the at least one battery, acquire, via the device to-be-charged, a current of each of the at least one battery, and for any one of the at least one battery, stop charging of the battery when a current of the battery reaches a corresponding preset threshold current.

In the charging apparatus provided herein, the first communication control circuit performs, via the first charging circuit, constant-current charging on the at least one battery at the first charging rate until the voltage across any one of the at least one battery reaches the first voltage. The first communication control circuit performs, via the first charging circuit, constant-voltage charging on the at least one battery, and for any one of the at least one battery, stops charging of the battery when the current of the battery reaches the corresponding preset threshold current. As such, the voltage across any one of the at least one battery can exceed the rated voltage through charging, and thus charging can be performed beyond limitation of rated parameters of the battery, which is possible to significantly shorten charging time and increase charging speed without adversely affecting service life of the battery.

To achieve the above purposes, in a third aspect, a device to-be-charged is provided. The device to-be-charged is configured to communicate with a charging apparatus when coupled with the charging apparatus via a charging interface. The device to-be-charged includes a second communication control circuit and a second charging circuit. The second communication control circuit is configured to operate as follows. The second communication control circuit is configured to send a first charging rate to the charging apparatus, such that the charging apparatus performs, via the second charging circuit, constant-current charging on at least one battery at the first charging rate until a voltage across any one of the at least one battery reaches a first voltage, where the first voltage is higher than a minimum rated voltage in rated voltages of the at least one battery. The second communication control circuit is configured to send a constant-voltage-charging instruction to the charging apparatus, such that the charging apparatus performs, via the second charging circuit, constant-voltage charging on the at least one battery, acquires a current of each of the at least one battery, and for any one of the at least one battery, stops charging of the battery when a current of the battery reaches a corresponding preset threshold current.

In the device to-be-charged provided herein, the second communication control circuit sends the first charging rate to the charging apparatus, such that the charging apparatus performs, via the second charging circuit, constant-current charging on the at least one battery at the first charging rate until the voltage across any one of the at least one battery reaches the first voltage. The second communication control circuit sends the constant-voltage-charging instruction to the charging apparatus, such that the charging apparatus performs, via the second charging circuit, constant-voltage charging on the at least one battery, and for any one of the at least one battery, stops charging of the battery when the current of the battery reaches the corresponding preset threshold current. In this way, the voltage across any one of the at least one battery can exceed the rated voltage through charging, which is beneficial to charging beyond limitation of rated parameters of the battery. As such, it is possible to significantly shorten charging time and increase charging speed without adversely affecting service life of the battery.

To achieve the above purposes, in a fourth aspect, a charging system is provided. The charging system includes the charging apparatus described in the second aspect and the device to-be-charged described in the third aspect.

With aid of the charging system provided herein, a battery can be charged until a voltage across the battery reaches a voltage that exceeds a rated voltage, which is possible to charge the battery beyond limitation of rated parameters of the battery. As such, charging time can be significantly shortened and charging speed can be increased without adversely affecting service life of the battery.

To achieve the above purposes, in a fifth aspect, a non-transitory computer-readable storage medium is provided. The non-transitory computer-readable storage medium is configured to store programs for quick charging of a battery which, when executed by a processor, are operable with the processor to perform the method for quick charging of a battery described in the first aspect.

To achieve the above purposes, in a sixth aspect, a method for quick charging of a battery is provided. The method includes the following. Constant-current charging is performed on at least one battery at a second charging rate until a voltage across any one of the at least one battery reaches a second voltage. Constant-current charging is performed on the at least one battery at a third charging rate until the voltage across any one of the at least one battery reaches a third voltage, where the third charging rate is lower than the second charging rate, the third voltage is higher than the second voltage, and the third voltage is higher than a minimum rated voltage in rated voltages of the at least one battery. Constant-voltage charging is performed on the at least one battery. A current of each of the at least one battery is acquired, and for any one of the at least one battery, charging of the battery is stopped when a current of the battery reaches a corresponding preset threshold current.

According to the method provided herein, constant-current charging is performed on the at least one battery at the second charging rate until the voltage across any one of the at least one battery reaches the second voltage. Constant-current charging is performed on the at least one battery at the third charging rate until the voltage across any one of the at least one battery reaches the third voltage that is higher than the second voltage. Constant-voltage charging is performed on the at least one battery, and for any one of the at least one battery, charging of that battery is stopped when the current of the battery reaches the corresponding preset threshold current. In this way, the voltage across any one of the at least one battery can exceed the rated voltage through charging, and thus charging can be performed beyond limitation of rated parameters of the battery, which can significantly shorten charging time and increase charging speed while not adversely affecting service life of the battery.

To achieve the above purposes, in a seventh aspect, a charging apparatus is provided. The charging apparatus is configured to communicate with a device to-be-charged when coupled with the device to-be-charged via a charging interface. The charging apparatus includes a first communication control circuit and a first charging circuit. The first communication control circuit is configured to operate as follows. The first communication control circuit is configured to perform, via the first charging circuit, constant-current charging on at least one battery at a second charging rate until a voltage across any one of the at least one battery reaches a second voltage. The first communication control circuit is configured to perform, via the first charging circuit, constant-current charging on the at least one battery at a third charging rate until the voltage across any one of the at least one battery reaches a third voltage, where the first communication control circuit is configured to acquire a voltage across each of the at least one battery via the device to-be-charged, the third charging rate is lower than the second charging rate, the third voltage is higher than the second voltage, and the third voltage is higher than a minimum rated voltage in rated voltages of the at least one battery. The first communication control circuit is configured to perform, via the first charging circuit, constant-voltage charging on the at least one battery, acquire, via the device to-be-charged, a current of each of the at least one battery, and for any one of the at least one battery, stop charging of the battery performed via the first charging circuit when a current of the battery reaches a corresponding preset threshold current.

In the charging apparatus provided herein, the first communication control circuit performs, via the first charging circuit, constant-current charging on the at least one battery at the second charging rate until the voltage across any one of the at least one battery reaches the second voltage. The first communication control circuit performs, via the first charging circuit, constant-current charging on the at least one battery at the third charging rate until the voltage across any one of the at least one battery reaches the third voltage. The first communication control circuit performs, via the first charging circuit, constant-voltage charging on the at least one battery, and for any one of the at least one battery, stops charging of that battery performed via the first charging circuit when the current of the battery reaches the corresponding preset threshold current. In this way, the voltage across any one of the at least one battery can reach a voltage that is higher than the rated voltage through charging, which is conducive to charging beyond limitation of rated parameters of the battery. As such, charging time can be significantly shortened and charging speed can be increased without adversely affecting service life of the battery.

To achieve the above purposes, in an eighth aspect, a device to-be-charged is provided. The device to-be-charged is configured to communicate with a charging apparatus when coupled with the charging apparatus via a charging interface. The device to-be-charged includes a second communication control circuit and a second charging circuit. The second communication control circuit is configured to operate as follows. The second communication control circuit is configured to send a second charging rate to the charging apparatus, such that the charging apparatus performs, via the second charging circuit, constant-current charging on at least one battery at the second charging rate until a voltage across any one of the at least one battery reaches a second voltage. The second communication control circuit is configured to send a third charging rate to the charging apparatus, such that the charging apparatus performs, via the second charging circuit, constant-current charging on the at least one battery at the third charging rate until the voltage across any one of the at least one battery reaches a third voltage, where the third charging rate is lower than the second charging rate, the third voltage is higher than the second voltage, and the third voltage is higher than a minimum rated voltage in rated voltages of the at least one battery. The second communication control circuit is configured to send a constant-voltage-charging instruction to the charging apparatus, such that the charging apparatus performs, via the second charging circuit, constant-voltage charging on the at least one battery, acquires a current of each of the at least one battery, and for any one of the at least one battery, stops charging of the battery when a current of the battery reaches a corresponding preset threshold current.

In the device to-be-charged provided herein, the second communication control circuit sends the second charging rate to the charging apparatus, such that the charging apparatus performs, via the second charging circuit, constant-current charging on the at least one battery at the second charging rate until the voltage across any one of the at least one battery reaches the second voltage. The second communication control circuit sends the third charging rate to the charging apparatus, such that the charging apparatus performs, via the second charging circuit, constant-current charging on the at least one battery at the third charging rate until the voltage across any one of the at least one battery reaches the third voltage, where the third charging rate is lower than the second charging rate, and the third voltage is higher than the second voltage. The second communication control circuit sends the constant-voltage-charging instruction to the charging apparatus, such that the charging apparatus performs, via the second charging circuit, constant-voltage charging on the at least one battery, acquires the current of each of the at least one battery, and for any one of the at least one battery, stops charging of that battery when the current of the battery reaches the corresponding preset threshold current. In this way, a battery can be charged until a voltage that is higher than a rated voltage is reached, and thus charging can be performed beyond limitation of rated parameters of the battery, which can significantly shorten charging time and increase charging speed without adversely affecting service life of the battery.

To achieve the above purposes, in a ninth aspect, a charging system is provided. The charging system includes the charging apparatus described in the seventh aspect and the device to-be-charged in the eighth aspect.

With aid of the charging system provided herein, a battery can be charged until a voltage across the battery reaches a voltage that exceeds a rated voltage, thus achieving charging beyond limitation of rated parameters of the battery, which can significantly shorten charging time and increase charging speed without adversely affecting service life of the battery.

To achieve the above purposes, in a tenth aspect, a non-transitory computer-readable storage medium is provided. The non-transitory computer-readable storage medium is configured to store programs for quick charging of a battery which, when executed by a processor, are operable with the processor to perform the method for quick charging of a battery described in the sixth aspect.

The additional aspects and advantages of the disclosure will be partially given in the following description, and some will become apparent from the following description, or be understood through the practice of the disclosure.

### BRIEF DESCRIPTION OF THE DRAWINGS

The above and/or additional aspects and advantages of implementations will become apparent and easy to understand from the following description of implementations in conjunction with the accompanying drawings.
FIG 1 is a schematic structural diagram of a charging apparatus and a device to-be-charged according to implementations.
FIG 2 is a flowchart of a method for quick charging of a battery (including one battery) according to implementations.
FIG 3 is a flowchart of a method for quick charging of a battery (including multiple batteries) according to implementations.
FIG 4 is a schematic block diagram of a charging apparatus according to implementations.
FIG 5 is a schematic block diagram of a device to-be-charged according to implementations.
FIG 6 is a schematic block diagram of a charging system according to implementations.
FIG 7 is a flowchart of a method for quick charging of a battery (including one battery) according to other implementations.
FIG 8 is a flowchart of a method for quick charging of a battery (including multiple batteries) according to other implementations.
FIG 9 is a schematic block diagram of a charging apparatus according to other implementations.
FIG 10 is a schematic block diagram of a device to-be-charged according to other implementations.
FIG 11 is a schematic block diagram of a charging system according to other implementations.

### DETAILED DESCRIPTION

The following will describe implementations in detail, and examples of implementations herein will be illustrated in the accompanying drawings, in which the same or similar reference numerals denote the same or similar components or components having the same or similar functions throughout the context. Implementations hereinafter described with reference to the accompanying drawings are illustrative and intended for explaining, rather than limiting, the present disclosure.

It should be noted that, a charging apparatus is provided in implementations. The charging apparatus can be used to charge a device to-be-charged. According to implementations herein, the charging apparatus can output a voltage/current with a pulsating waveform to charge the device to-be-charged. The voltage/current with a pulsating waveform periodically changes magnitude. Compared with a conventional constant-voltage constant-current charging scheme, by applying the voltage/current with a pulsating waveform, lithium precipitation of a lithium battery can be reduced, thereby prolonging service life of a battery. On the other hand, probability and strength of arching of a contact of a charging interface can be reduced and thus service life of the charging interface can be prolonged. In addition, it is possible to reduce polarization of the battery, increase charging speed, and reduce heat generation of the battery, thus ensuring safety and reliability during charging. Furthermore, since the charging apparatus outputs the voltage with a pulsating waveform, it is unnecessary to provide the charging apparatus with an electrolytic capacitor, which can allow for not only simplification and miniaturization of the charging apparatus but also significantly reduced cost.

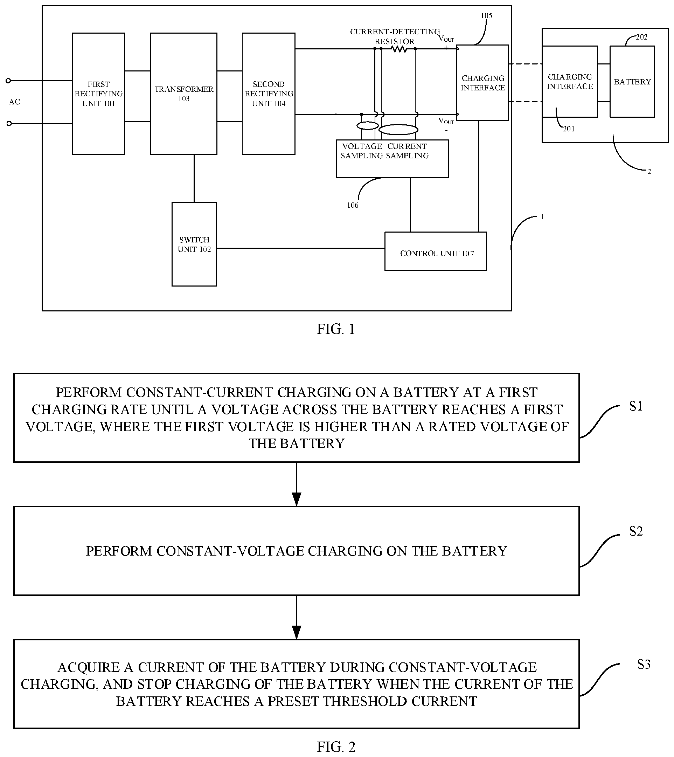

As illustrated in FIG 1, in some examples, a charging apparatus 1 includes a first rectifying unit 101, a switch unit 102, a transformer 103, a second rectifying unit 104, a first charging interface 105, a sampling unit 106, and a control unit 107.

The first rectifying unit 101 is configured to rectify an input alternating current (AC), for example, mains electricity (such as an AC of 220V (volt), to output a voltage with a first pulsating-waveform (such as a voltage in the form of steamed-bun wave). The first rectifying unit 101 may be a full-bridge rectifying circuit composed of four diodes.

The switch unit 102 is configured to modulate, according to a control signal, the voltage with a first pulsating waveform. The switch unit 102 may be composed of a metal-oxide semiconductor (MOS) transistor. Through pulse width modulation (PWM) control on the MOS transistor, chopping modulation can be performed on the steamed-bun wave voltage.

The transformer 103 is configured to output a voltage with a second pulsating waveform according to the voltage with a first pulsating waveform subjected to modulation.

The second rectifying unit 104 is configured to rectify the voltage with a second pulsating waveform to output a voltage with a third pulsating waveform. In some examples, the second rectifying unit 104 can be composed of a diode or a MOS transistor. The second rectifying unit 104 can be configured to perform secondary-side synchronous rectification, such that the third pulsating waveform can remain synchronous to the first pulsating waveform subjected to modulation. It should be noted that, the phrase "the third pulsating waveform remains synchronous to the first pulsating waveform subjected to modulation" can be comprehended as follows. A phase of the third pulsating waveform coincides with that of the first pulsating waveform subjected to modulation, and an amplitude trend of the third pulsating waveform is consistent with that of the first pulsating waveform subjected to modulation.

The first charging interface 105 is coupled with the second rectifying unit 104. The first charging interface 105 is configured to output the voltage with a third pulsating waveform to charge a device to-be-charged 2.

The sampling unit 106 is configured to sample an output voltage and/or an output current of the second rectifying unit 104, to obtain a sampled voltage value and/or a sampled current value.

The control unit 107 is coupled with the sampling unit 106 and the switch unit 102 respectively. The control unit 107 is configured to output a control signal to the switch unit 102 and adjust, according to the sampled voltage value and/or the sampled current value, a duty cycle of the control signal, such that the voltage with a third pulsating waveform outputted by the second rectifying unit 104 meets charging requirements.

As illustrated in FIG 1, in some examples, the device to-be-charged 2 includes a second charging interface 201 and a battery 202. The second charging interface 201 is coupled with the battery 202. The second charging interface 201 is configured to apply the voltage with a third pulsating waveform to the battery 202 for charging, when coupled with the first charging interface 105.

In some examples, the charging apparatus 1 can further include a driving unit, for example, a metal-oxide-semiconductor field-effect transistor (MOSFET) driver. The driving unit is coupled between the switch unit 102 and the control unit 107. The driving unit is configured to drive, according to the control signal, the switch unit 102 to be closed (that is, in an on-state) or open (that is, in an off-state). It should be noted that, in other examples, the driving unit can be integrated into the control unit 107.

In some examples, the charging apparatus 1 can further include an auxiliary winding and a power supplying unit. The auxiliary winding is configured to generate a voltage with a fourth pulsating waveform according to the voltage with a first pulsating waveform subjected to modulation. The power supplying unit is coupled with the auxiliary winding. The power supplying unit ,which may include, for example, a filtering-and-voltage-stabilizing module, a voltage converting module, and other components, is configured to convert the voltage with a fourth pulsating waveform to output a direct current (DC) for powering the driving unit and/or the control unit 107 respectively. The power supplying unit may be composed of a small filter capacitor, a voltage stabilizing chip, and other elements, to process and convert the voltage with a fourth pulsating waveform to output a low-voltage DC, for example, 3.3V, 5V, etc.

In other words, a power supply voltage supplied to the driving unit can be obtained through conversion of the voltage with a fourth pulsating waveform performed by the power supplying unit. When the control unit 107 is disposed at a primary side, a power supply voltage supplied to the control unit 107 can also be obtained through conversion of the voltage with a fourth pulsating waveform performed by the power supplying unit. When the control unit 107 is disposed at the primary side, the power supplying unit provides two output DCs to power the driving unit and the control unit 107 respectively. An opto-isolation unit can be disposed between the control unit 107 and the sampling unit 106 to achieve signal isolation between the primary and the secondary of the charging apparatus 1.

When the control unit 107 is disposed at the primary side and integrated with the driving unit, the power supplying unit only powers the control unit 107. When the control unit 107 is disposed at a secondary side and the driving unit is disposed at the primary side, the power supplying unit only powers the driving unit. The control unit 107 is powered on the secondary side, for example, the voltage with a third pulsating waveform outputted by the second rectifying unit 104 is converted, with another power supplying unit, into a DC for powering the control unit 107.

In other examples, the charging apparatus 1 can further include a first voltage-detecting unit. The first voltage-detecting unit is coupled with the auxiliary winding and the control unit 107 respectively. The first voltage-detecting unit is configured to detect the voltage with a fourth pulsating waveform to generate a detected voltage value. The control unit 107 can be further configured to adjust, according to the detected voltage value, the duty cycle of the control signal.

In other words, the control unit 107 can determine an output voltage of the second rectifying unit 104 according to an output voltage of the auxiliary winding detected by the first voltage-detecting unit. Then the control unit 107 adjusts, according to the detected voltage value, the duty cycle of the control signal, such that an output of the second rectifying unit 104 meets charging requirements of the battery.

It should be understood that, the charging apparatus provided herein can be an apparatus for quick charging, for example, an apparatus for quick charging with low voltage and large current or an apparatus for quick charging with high voltage and small current. Alternatively, the charging apparatus provided herein can be a normal charging apparatus, for example, a 5V/1A (ampere) charging apparatus in the related art. The disclosure is not limited in this regard.

Based on the above charging apparatus for a device to-be-charged, implementations provide a method for quick charging of a battery, a charging apparatus, a device to-be-charged, and a charging system.

The following will describe with reference to the accompanying drawings the method for quick charging of a battery, the charging apparatus, the device to-be-charged, and the charging system provided in implementations.

It should be noted that, during charging of a lithium-ion battery, an electric potential of a cathode continuously increases, and an electric potential of an anode continuously decreases. When the electric potential of the anode is lower than 0V, Li+ (lithium ion) will precipitate on the anode, forming lithium dendritic crystal (that is, "lithium precipitation"). Lithium precipitation can, in addition to affecting electrochemical performance of the battery, adversely affect safety of the battery. Therefore, it is necessary to avoid lithium precipitation of the battery as much as possible when the battery is in use.

By analyzing a charging curve of the battery obtained with aid of a three-electrode method, the inventor of the disclosure has found that, during charging, a charging parameter (such as charging voltage, charging current, and the like) of the battery can exceed a rated parameter of the battery as long as the electric potential of the cathode has not reached an electric potential at which lithium precipitation occurs. For example, a rated voltage of the battery is 4.4V, and a rated charging current of the battery is 3.0A. During charging, the battery can be charged until a voltage across the battery reaches more than 4.4V, and a current of the battery can also exceed the rated charging current of 3.0A.

It should be understood that, the rated parameter of the battery (such as rated charging rate, rated voltage, rated capacity, etc) can be specified by a battery manufacturer.

Therefore, voltage *Vₐ* at which lithium precipitation occurs during charging of the battery can be obtained through a test. In other words, when the voltage across the battery has not reached *Vₐ,* lithium precipitation does not occur during the whole charging process of the battery. After *Vₐ* is obtained, a charging voltage of the battery that exceeds the rated voltage of the battery can be obtained according to *Vₐ,* for example, a first voltage and a third voltage that will be described in the following implementations.

According to implementations, the charging voltage that exceeds the rated voltage of the battery is set in advance. During charging, constant-current charging can be first performed on the battery until the voltage across the battery reaches the charging voltage that exceeds the rated voltage of the battery. Then constant-voltage charging can be performed on the battery. As such, charging can be performed beyond limitation of rated parameters of the battery, which is conducive to greatly shortening charging time and increasing charging speed without affecting service life of the battery.

It should be noted that, according to implementations herein, when coupled with the device to-be-charged via a charging interface, the charging apparatus can perform two-way communication with the device to-be-charged. The charging apparatus can charge a battery of the device to-be-charged via a power line of the charging interface and communicate with the device to-be-charged via a data line of the charging interface.

According to implementations, the device to-be-charged can be a terminal. The "terminal" may include, but is not limited to, a smart phone, a computer, a personal digital assistant (PDA), a wearable device, a Bluetooth headphone, a game device, a camera device, and the like. The charging apparatus may be a device that can charge the terminal, such as an adaptor, a power bank (portable charger), a vehicle charger, or the like. The method for quick charging of a battery provided in implementations is applicable to the charging apparatus or the device to-be-charged. When the method is applied to the charging apparatus, the device to-be-charged can acquire state parameters of the battery (such as voltage, current, etc) and send, via the data line of the charging interface, the state parameters to the charging apparatus. Alternatively, when the method is applied to the device to-be-charged, the device to-be-charged can send charging parameters (such as charging voltage, charging current, charging mode, etc) to the charging apparatus.

It should be understood that, the device to-be-charged may include one battery or multiple batteries coupled in series. The method for quick charging of a battery will be hereinafter described in detail in conjunction with specific examples (one battery or multiple batteries).

1) The device to-be-charged includes one battery.

FIG 2 is a flowchart of a method for quick charging of a battery according to implementations. As illustrated in FIG 2, the method includes the following.

At block S1, constant-current charging is performed on the battery at a first charging rate until a voltage across the battery reaches a first voltage, where the first voltage is higher than a rated voltage of the battery.

The first charging rate and the first voltage can be set in advance. When constant-current charging is performed on the battery at the first charging rate, a charging current can be adjusted to correspond to the first charging rate for constant-current charging of the battery of the device to-be-charged. In other words, during constant-current charging, the charging current can remain constant, and the voltage across the battery gradually increases as charging progresses.

According to implementations, the first charging rate may be lower than or equal to a rated charging rate of the battery. For example, when the rated charging rate of the battery is 1.5C (coulomb), the first charging rate may be 1.3C, where a charging rate of the battery refers to a ratio of a charging current of the battery to a rated capacity of the battery.

The first voltage can be 1.01∼1.2 times the rated voltage. As an example, the first voltage can be 1.01∼1.02 times the rated voltage. For example, when the rated voltage is 4.4V, the first voltage can be 4.45V or even higher. In addition, the rated voltage of the battery is lower than (that is, less than) a voltage at which lithium precipitation occurs during charging of the battery. In order to ensure no lithium precipitation during charging, the first voltage is also lower than the voltage at which lithium precipitation occurs during charging of the battery.

It should be noted that, the first voltage can be determined through an experimental test. Different models of batteries can correspond to different first voltages. The first voltage can be determined offline, and the first voltage determined through the test can be directly used during interaction.

It should be understood that, the first voltage is determined according to the voltage at which lithium precipitation occurs during charging of the battery. For example, in order to determine a first voltage of each model of battery, the voltage at which lithium precipitation occurs during charging of the battery can be first determined. Then a suitable first voltage can be selected according to the voltage at which lithium precipitation occurs during charging of the battery, in order to select the first voltage that is higher than the rated voltage while ensuring no lithium precipitation during charging. In other words, the first voltage selected can be higher than the rated voltage. The first voltage can be high enough as long as no lithium precipitation occurs during the whole charging process.

At block S2, constant-voltage charging is performed on the battery.

According to implementations, the first voltage is applied to the battery for constant-voltage charging.

At block S3, a current of the battery is acquired, and charging of the battery is stopped when the current of the battery reaches a preset threshold current.

If the first voltage is applied to the battery for constant-voltage charging, a charging voltage of the battery can be adjusted to the first voltage to be applied to the battery of the device to-be-charged for constant-voltage charging. In other words, during constant-voltage charging, the charging voltage can remain constant, and the current of the battery gradually decreases as charging progresses.

As an example, after the voltage across the battery reaches the first voltage through the constant-current charging at block S1, a capacity of the battery increases from 0% of the rated capacity to a relatively high capacity, for example, more than 80% (or equal to 80%). When the constant-voltage charging at block S2 is performed on the battery, it is only necessary to fully charge a remaining capacity (that is, less than 20% of the rated capacity) of the battery to complete the remaining charging.

It can be understood that, with the progress of constant-voltage charging, the capacity of the battery increases, a current required for maintaining the first voltage decreases, and when the current of the battery reaches the preset threshold current, charging is stopped. In this situation, the battery can be considered to be fully charged. In other words, when the first voltage is applied to the battery for constant-voltage charging, the charging voltage is maintained at the first voltage. The current of the battery can be acquired in real time, and when the current of the battery reaches the preset threshold current, charging of the battery is stopped.

As such, by applying the first voltage to the battery for constant-voltage charging, it is possible to allow for charging cut-off when the current applied for charging is relatively larger than the current used in the related art, which can shorten charging time, increase charging speed, and improve charging efficiency. It should be understood that, the charging parameters described above (that is, the first charging rate, the first voltage, and the preset threshold current) can be stored in a charging apparatus or the device to-be-charged, and this depends on whether the method provided herein is performed by the charging apparatus or the device to-be-charged.

For example, when the method is applied to the charging apparatus, the device to-be-charged is responsible for acquiring state parameters of the battery (here, the voltage across the battery and the current of the battery), and sending, via a data line of a charging interface, the voltage across the battery and the current of the battery to the charging apparatus. When coupled with the device to-be-charged via the charging interface, the charging apparatus performs constant-current charging on the battery at the first charging rate (that is, adjusts the charging current to correspond to the first charging rate) and acquires, via the device to-be-charged, the voltage across the battery during the constant-current charging. When the voltage across the battery reaches the first voltage, the charging apparatus applies the first voltage to the battery for constant-voltage charging, that is, adjusts the charging voltage to the first voltage. During the constant-voltage charging, the charging apparatus acquires the current of the battery via the device to-be-charged and stops charging when the current of the battery reaches the preset threshold current. For another example, when the method is applied to the device to-be-charged, the device to-be-charged is not only responsible for acquiring the state parameters of the battery (here, the voltage across the battery and the current of the battery) but also responsible for sending charging parameters (here, the first charging rate, the first voltage, and the preset threshold current) to the charging apparatus. When coupled with the charging apparatus via the charging interface, the device to-be-charged sends the first charging rate and a constant-current-charging instruction to the charging apparatus. The charging apparatus, upon receiving the first charging rate and the constant-current-charging instruction, performs constant-current charging on the battery at the first charging rate received, that is, adjusts the charging current to correspond to the first charging rate. The device to-be-charged acquires the voltage across the battery during the constant-current charging, and when the voltage across the battery reaches the first voltage, sends information indicating the first voltage and a constant-voltage-charging instruction to the charging apparatus. The charging apparatus applies the first voltage to the battery for constant-voltage charging, that is, adjusts the charging voltage to the first voltage. The device to-be-charged acquires the current of the battery during the constant-voltage charging and stops charging when the current of the battery reaches the preset threshold current.

In connection with examples in FIG 1, when constant-current charging is performed on the battery at the first charging rate, the control unit can adjust the duty cycle of the control signal according to the first charging rate and the output current of the second rectifying unit, such that a current with a third pulsating waveform outputted by the second rectifying unit meets requirements on constant-current charging at the first charging rate. When the first voltage is applied to the battery for constant-voltage charging, the control unit can adjust the duty cycle of the control signal according to the first voltage and the output voltage of the second rectifying unit, such that the voltage with a third pulsating waveform outputted by the second rectifying unit meets requirements on constant-voltage charging with the first voltage.

As such, according to the method provided herein, constant-current charging is first performed on the battery at the first charging rate until the voltage across the battery reaches the first voltage. Then the first voltage is applied to the battery for constant-voltage charging until the current of the battery reaches the preset threshold current. In this way, the battery can be charged until the voltage across the battery exceeds the rated voltage, and thus charging can be performed beyond limitation of rated parameters of the battery, which can significantly shorten charging time and increase charging speed without adversely affecting service life of the battery.

2) The device to-be-charged includes multiple batteries.

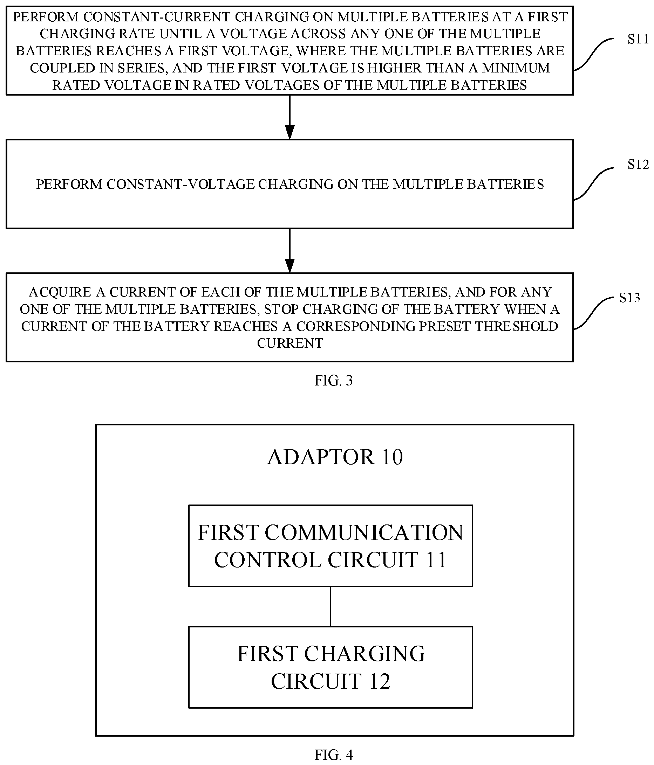

FIG 3 is a flowchart of a method for quick charging of a battery according to implementations. As illustrated in FIG 3, the method includes the following.

At block S11, constant-current charging is performed on multiple batteries at a first charging rate until a voltage across any one of the multiple batteries reaches a first voltage, where the first voltage is higher than a minimum rated voltage in rated voltages of the multiple batteries.

The multiple batteries can be coupled in series. The first charging rate and the first voltage can be set in advance. When constant-current charging is performed on the multiple batteries at the first charging rate, a charging current can be adjusted to correspond to the first charging rate for constant-current charging of the multiple batteries of the device to-be-charged. In other words, during constant-current charging, the charging current can remain constant, and a voltage across each of the multiple batteries gradually increases as charging progresses.

In addition, during constant-current charging of the multiple batteries, the voltage across each of the multiple batteries can be monitored, and balance control can be performed on the multiple batteries according to the voltage across each of the multiple batteries, such that the voltage across each of the multiple batteries remains almost equal to each other. Therefore, constant-current charging can be performed on the multiple batteries until the voltage across any one of the multiple batteries reaches the first voltage.

In some implementations, the first charging rate is lower than or equal to a rated charging rate of each of the multiple batteries. It should be understood that, a rated parameter of each of the multiple batteries (such as rated charging rate or rated voltage) may be the same or different. As an example, the rated charging rate of each of the multiple batteries is the same. If the rated charging rate of each of the multiple batteries is 1.5C, the first charging rate can be 1.3C. As another example, the rated charging rate of each of the multiple batteries is different. If a minimum rated charging rate in rated charging rates of the multiple batteries is 1.5C, the first charging rate can be 1.3C.

In some implementations, the first voltage can be 1.01∼1.2 times the minimum rated voltage. It should be understood that, different batteries may have the same rated voltage or different rated voltages. For example, when each battery has a rated voltage of 4.4V, the first voltage may be 1.01∼1.2 times the rated voltage of 4.4V, such as 4.45V or even higher. For another example, the multiple batteries include two batteries, where a first battery of the two batteries has a rated voltage of 4.4V and a second battery has a rated voltage of 4.2V In this situation, the first voltage may be 4.25V or even higher.

In addition, a rated voltage of each of the multiple batteries is lower than (that is, less than) a voltage at which lithium precipitation occurs during charging of the battery. In order to ensure no lithium precipitation during charging, the first voltage is also lower than a voltage at which lithium precipitation occurs during charging of each of the multiple batteries.

It should be noted that, the first voltage can be determined through an experimental test. The first voltage can be determined offline, and the first voltage determined through the test can be directly used during interaction.

It should be understood that, the first voltage can be determined according to the voltage at which lithium precipitation occurs during charging of each of the multiple batteries. For example, in order to determine the first voltage, the voltage at which lithium precipitation occurs during charging of each of the multiple batteries can be first determined. Then a suitable first voltage can be selected according to the voltage at which lithium precipitation occurs during charging of each of the multiple batteries, in order to select the first voltage that is higher than the rated voltage of each of the multiple batteries while ensuring no lithium precipitation during charging. In other words, the first voltage selected can be higher than the rated voltage of each of the multiple batteries. The first voltage can be high enough as long as no lithium precipitation occurs during the whole charging process.

At block S12, constant-voltage charging is performed on the multiple batteries.

A sum of multiple first voltages is applied to the multiple batteries for constant-voltage charging.

At block S13, a current of each of the multiple batteries is acquired, and for any one of the multiple batteries, charging of the battery is stopped when a current of the battery reaches a corresponding preset threshold current.

As an example, the multiple batteries include *N* batteries, where *N* is an integer greater than one. In this situation, a sum of *N* first voltages (that is, *V₁*×*N*) can be applied to the *N* batteries for constant-voltage charging. During the constant-voltage charging, the voltage across each of the multiple batteries can be monitored, and balance control can be performed on the multiple batteries according to the voltage across each of the multiple batteries, such that the voltage across each of the multiple batteries remains almost equal to each other.

In addition, the *N* batteries correspond to *N* preset threshold currents respectively. During the constant-voltage charging, a current of each of the *N* batteries can be detected. When a current of an *i^{th}* battery reaches a preset threshold current of the *i^{th}* battery, charging of the *i^{th}* battery is stopped, where 1≤*i*≤*N.* For example, charging of the *i^{th}* battery can be stopped by disconnecting the *i^{th}* battery via a switch.

Furthermore, after charging of the *i^{th}* battery is stopped, the sum of *N* first voltages can be adjusted to a sum of *(N-1)* first voltages to be applied to the *N* batteries for constant-voltage charging, and balance control is performed on the remaining *(N-1)* batteries. At the same time, a current of each of the remaining *(N-1)* batteries is monitored. When a current of a *j^{th}* battery reaches a preset threshold current of the *j^{th}* battery, charging of the *j^{th}* battery is stopped, where *j≠i,* and 1≤*j*≤*N.*

The above steps are thus repeated until the current of each of the *N* batteries reaches the corresponding preset threshold current, and thus the whole charging process is completed.

If the sum of multiple first voltages is applied to the multiple batteries for constant-voltage charging, a charging voltage of the multiple batteries can be adjusted to the sum of multiple first voltages, to be applied to the multiple batteries of the device to-be-charged for constant-voltage charging. In other words, during constant-voltage charging, the charging voltage can remain constant, and the current of each of the multiple batteries gradually decreases as charging progresses.

As an example, after the voltage across any one of the multiple batteries reaches the first voltage through the constant-current charging at block S11, a capacity of any one of the multiple batteries increases from 0% of the rated capacity to a relatively high capacity, for example, more than 80% (or equal to 80%). When the constant-voltage charging at block S12 is performed on the multiple batteries, it is only necessary to fully charge a remaining capacity of each of the multiple batteries to complete the remaining charging.

It can be understood that, with the progress of constant-voltage charging, a capacity of a battery increases, a current required for maintaining the first voltage decreases, and when a current of the battery reaches a preset threshold current, charging is stopped. In this situation, the battery can be considered to be fully charged. In other words, when the sum of multiple first voltages is applied to the multiple batteries for constant-voltage charging, the charging voltage is maintained at the sum of multiple first voltages. The current of each of the multiple batteries can be acquired in real time, and for any one of the multiple batteries, when a current of that battery reaches the corresponding preset threshold current, charging of the battery is stopped.

As such, by applying the sum of multiple first voltages to the multiple batteries for constant-voltage charging, a large cut-off current can be achieved, which can shorten charging time, increase charging speed, and improve charging efficiency.

It should be understood that, the charging parameters described above (that is, the first charging rate, the first voltage, and the preset threshold current) can be stored in a charging apparatus or the device to-be-charged, and this depends on whether the method provided herein is performed by the charging apparatus or the device to-be-charged.

For example, when the method is applied to the charging apparatus, the device to-be-charged is responsible for acquiring state parameters of the battery (here, a voltage across the battery and a current of the battery), and sending, via a data line of a charging interface, the voltage across the battery and the current of the battery to the charging apparatus. When coupled with the device to-be-charged via the charging interface, the charging apparatus performs constant-current charging on the battery at the first charging rate (that is, adjusts the charging current to correspond to the first charging rate) and acquires, via the device to-be-charged, the voltage across each of the multiple batteries during the constant-current charging. When the voltage across any one of the multiple batteries reaches the first voltage, the charging apparatus applies the sum of multiple first voltages to the multiple batteries for constant-voltage charging, that is, adjusts the charging voltage to the sum of multiple first voltages. During the constant-voltage charging, the charging apparatus acquires the current of each of the multiple batteries via the device to-be-charged, and for any one of the multiple batteries, stops charging of that battery when the current of the battery reaches the corresponding preset threshold current.

For another example, when the method is applied to the device to-be-charged, the device to-be-charged is not only responsible for acquiring the state parameters of the battery (here, the voltage across the battery and the current of the battery) but also responsible for sending charging parameters (here, the first charging rate, the first voltage, and the preset threshold current) to the charging apparatus. When coupled with the charging apparatus via the charging interface, the device to-be-charged sends the first charging rate and a constant-current-charging instruction to the charging apparatus. The charging apparatus, upon receiving the first charging rate and the constant-current-charging instruction, performs constant-current charging on the multiple batteries at the first charging rate received, that is, adjusts the charging current to correspond to the first charging rate. The device to-be-charged acquires the voltage across each of the multiple batteries during the constant-current charging, and when the voltage across any one of the multiple batteries reaches the first voltage, sends information indicating the sum of multiple first voltages and a constant-voltage-charging instruction to the charging apparatus. The charging apparatus applies the sum of multiple first voltages to the multiple batteries for constant-voltage charging, that is, adjusts the charging voltage to the sum of multiple first voltages. The device to-be-charged acquires the current of each of the multiple batteries during the constant-voltage charging, and for any one of the multiple batteries, stops charging of that battery when the current of the battery reaches the corresponding preset threshold current.

In connection with examples in FIG 1, when constant-current charging is performed on the multiple batteries at the first charging rate, the control unit can adjust the duty cycle of the control signal according to the first charging rate and the output current of the second rectifying unit, such that a current with a third pulsating waveform outputted by the second rectifying unit meets requirements on constant-current charging at the first charging rate. When the sum of multiple first voltages is applied to the multiple batteries for constant-voltage charging, the control unit can adjust the duty cycle of the control signal according to the sum of multiple first voltages and the output voltage of the second rectifying unit, such that the voltage with a third pulsating waveform outputted by the second rectifying unit meets requirements on constant-voltage charging with the sum of multiple first voltages.

As such, according to the method provided herein, constant-current charging is first performed on the multiple batteries at the first charging rate until the voltage across any one of the multiple batteries reaches the first voltage. Then the sum of multiple first voltages is applied to the multiple batteries for constant-voltage charging until the current of each of the multiple batteries reaches the corresponding preset threshold current. In this way, the battery can be charged until the voltage across the battery exceeds the rated voltage, thus achieving charging beyond limitation of rated parameters of the battery, which can significantly shorten charging time and increase charging speed without adversely affecting service life of the battery.

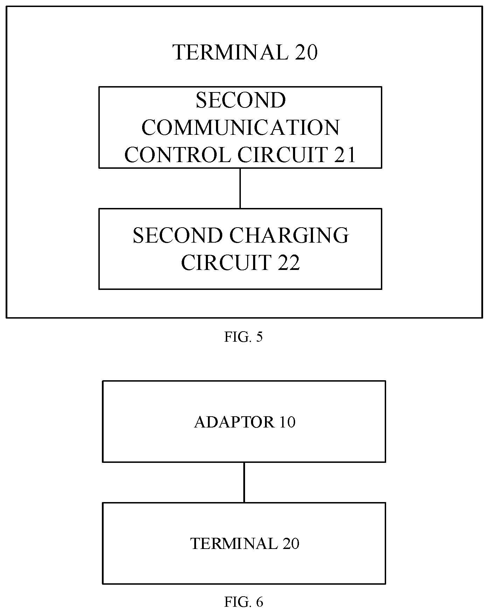

The following will describe in detail a charging apparatus and a device to-be-charged according to implementations with reference to FIG 4 and FIG 5. It should be noted that, the foregoing description of the implementations of the method for quick charging of a battery is also applicable to the charging apparatus and the device to-be-charged, which will not be repeated herein.

FIG 4 is a schematic block diagram of a charging apparatus according to implementations. The charging apparatus is configured to communicate with a device to-be-charged when coupled with the device to-be-charged via a charging interface. As illustrated in FIG 4, the charging apparatus 10 includes a first communication control circuit 11 and a first charging circuit 12.

The first communication control circuit 11 is configured to operate as follows. The first communication control circuit 11 is configured to perform, via the first charging circuit 12, constant-current charging on at least one battery at a first charging rate until a voltage across any one of the at least one battery reaches a first voltage, and acquire, via the device to-be-charged, a voltage across each of the at least one battery, where the first voltage is higher than a minimum rated voltage in rated voltages of the at least one battery. The first communication control circuit 11 is configured to perform, via the first charging circuit 12, constant-voltage charging on the at least one battery, acquire, via the device to-be-charged, a current of each of the at least one battery, and for any one of the at least one battery, stop charging of the battery when a current of the battery reaches a corresponding preset threshold current.

According to implementations, the at least one battery is coupled in series. The first communication control circuit 11 is configured to apply, via the first charging circuit 12, a sum of at least one first voltage to the at least one battery for constant-voltage charging.

It should be understood that, for the device to-be-charged provided herein, the division of units is only a division of logical functions, and there may exist other manners of division in practice. For example, in connection with the charging apparatus illustrated in in FIG 1, the first charging circuit 12 can include the first rectifying unit 101, the switch unit 102, the transformer 103, the second rectifying unit 104, and a power line of the first charging interface 105. The first communication control circuit 11 can include the sampling unit 106, the control unit 107, and a communication line of the first charging interface 105.

In some implementations, the first charging rate is lower than or equal to a rated charging rate of each of the at least one battery.

In some implementations, the first voltage is 1.01∼1.2 times the minimum rated voltage.

In some implementations, a rated voltage of each of the at least one battery is lower than a voltage at which lithium precipitation occurs during charging of the battery.

In this way, a voltage across a battery can exceed a rated voltage through charging, and thus charging can be performed beyond limitation of rated parameters of the battery, which is possible to significantly shorten charging time and increase charging speed without adversely affecting service life of the battery.

FIG 5 is a schematic block diagram of a device to-be-charged according to implementations. The device to-be-charged is configured to communicate with a charging apparatus when coupled with the charging apparatus via a charging interface. As illustrated in FIG 5, the device to-be-charged 20 includes a second communication control circuit 21 and a second charging circuit 22.

The second communication control circuit 21 is configured to operate as follows. The second communication control circuit 21 is configured to send a first charging rate to the charging apparatus, such that the charging apparatus performs, via the second charging circuit 22, constant-current charging on at least one battery at the first charging rate until a voltage across any one of the at least one battery reaches a first voltage, where the first voltage is higher than a minimum rated voltage in rated voltages of the at least one battery. The second communication control circuit 21 is configured to send a constant-voltage-charging instruction to the charging apparatus, such that the charging apparatus performs, via the second charging circuit 22, constant-voltage charging on the at least one battery, acquires a current of each of the at least one battery, and for any one of the at least one battery, stops charging of the battery when a current of the battery reaches a corresponding preset threshold current.

According to implementations, the at least one battery is coupled in series. The second communication control circuit 21 is configured to send to the charging apparatus a sum of at least one first voltage and the constant-voltage-charging instruction, such that the charging apparatus applies, via the second charging circuit 22, the sum of at least one first voltage to the at least one battery for constant-voltage charging.

It should be understood that, for the device to-be-charged provided herein, the division of units is only a division of logical functions, and there may exist other manners of division in practice. For example, in connection with the charging apparatus illustrated in FIG 1, the second charging circuit 22 can include a power line of the second charging interface 201 and a charging circuit disposed between the second charging interface 201 and the battery 202. The second communication control circuit 21 can include a communication line of the second charging interface 201 and a control unit that is coupled with the communication line and configured to control charging of the at least one battery performed by the charging apparatus.

In some implementations, the first charging rate is lower than or equal to a rated charging rate of each of the at least one battery.

In some implementations, the first voltage is 1.01∼1.2 times the minimum rated voltage.

In some implementations, a rated voltage of each of the at least one battery is lower than a voltage at which lithium precipitation occurs during charging of the battery.

In this way, a battery can be charged until a voltage that is higher than a rated voltage is reached, which is conducive to charging beyond limitation of rated parameters of the battery. As such, charging time can be significantly shortened and charging speed can be increased without adversely affecting service life of the battery.

FIG 6 is a schematic block diagram of a charging system according to implementations. The charging system 30 illustrated in FIG 6 includes the charging apparatus 10 illustrated in FIG 4 and the device to-be-charged 20 illustrated in FIG 5.

In this way, a voltage across a battery can exceed a rated voltage through charging, which can achieve charging beyond limitation of rated parameters of the battery. As such, charging time can be significantly shortened and charging speed can be increased without adversely affecting service life of the battery.

To achieve the above implementations, a non-transitory computer-readable storage medium is further provided. The non-transitory computer-readable storage medium is configured to store programs for quick charging of a battery which, when executed by a processor, are operable with the processor to perform the method for quick charging of a battery described in the foregoing implementations.

It should be understood that, the device to-be-charged may include one battery or multiple batteries coupled in series. A method for quick charging of a battery according to other implementations will be hereinafter described in detail in conjunction with specific examples (one battery or multiple batteries).

1) The device to-be-charged includes one battery.

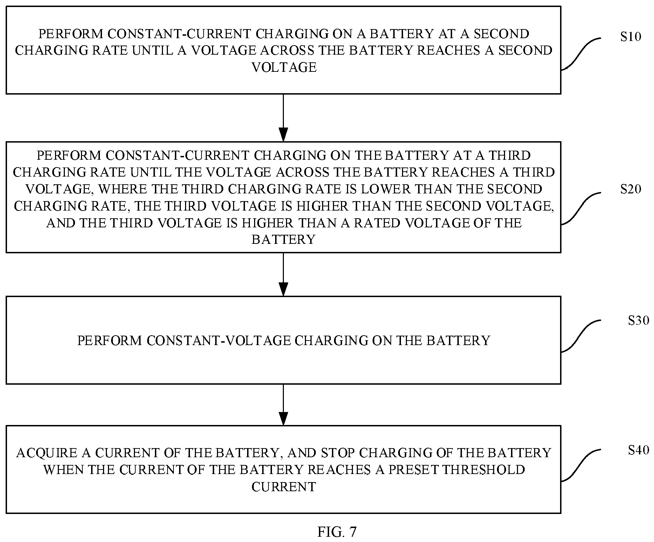

FIG 7 is a flowchart of a method for quick charging of a battery according to other implementations. As illustrated in FIG 7, the method includes the following.

At block S10, constant-current charging is performed on the battery at a second charging rate until a voltage across the battery reaches a second voltage.

At block S20, constant-current charging is performed on the battery at a third charging rate until the voltage across the battery reaches a third voltage, where the third charging rate is lower than the second charging rate, the third voltage is higher than the second voltage, and the third voltage is higher than a rated voltage of the battery.

The second charging rate and the second voltage can be set in advance. When constant-current charging is performed on the battery at the second charging rate, a charging current can be adjusted to correspond to the second charging rate for constant-current charging of the battery of the device to-be-charged. Similarly, the third charging rate and the third voltage can be set in advance. When constant-current charging is performed on the battery at the third charging rate, the charging current can be adjusted to correspond to the third charging rate for constant-current charging of the battery of the device to-be-charged. During constant-current charging, the charging current can remain constant, and the voltage across the battery gradually increases as charging progresses.

According to implementations, the second charging rate can be a rated charging rate of the battery, and the third charging rate can be lower than the rated charging rate of the battery. For example, the rated charging rate of the battery is 1.5C, and accordingly, the third charging rate may be 1.0C.

The second voltage can be the rated voltage of the battery. The third voltage can be 1.01∼1.2 times the rated voltage. For example, when the rated voltage is 4.4V, the third voltage can be 4.45V or even higher. The rated voltage of the battery is lower than (that is, less than) a voltage at which lithium precipitation occurs during charging of the battery. In order to ensure no lithium precipitation during charging, the third voltage is also lower than the voltage at which lithium precipitation occurs during charging of the battery.

It should be noted that, the third voltage can be determined through an experimental test. Different models of batteries can correspond to different third voltages. The third voltage can be determined offline, and the third voltage determined through the test can be directly used during interaction.

It should be understood that, the third voltage can be determined according to the voltage at which lithium precipitation occurs during charging of the battery. For example, in order to determine a third voltage of each model of battery, the voltage at which lithium precipitation occurs during charging of the battery can be first determined. Then a suitable third voltage can be selected according to the voltage at which lithium precipitation occurs during charging of the battery, in order to select the third voltage that is higher than the rated voltage while ensuring no lithium precipitation during charging. In other words, the third voltage selected can be higher than the rated voltage. The third voltage can be high enough as long as no lithium precipitation occurs during the whole charging process.

According to implementations herein, constant-current charging is first performed on the battery at the rated charging rate of the battery until the voltage across the battery reaches the rated voltage of the battery. After the voltage across the battery reaches the rated voltage of the battery, constant-current charging is performed on the battery at the third charging rate that is lower than the rated charging rate of the battery until the voltage across the battery reaches the third voltage that is higher than the rated voltage. As such, it is possible to further increase charging speed and improve charging efficiency, and on the other hand, the voltage across the battery can be accurately maintained at the third voltage, thereby ensuring no lithium precipitation during the whole charging process.

At block S30, constant-voltage charging is performed on the battery.

According to implementations, the third voltage is applied to the battery for constant-voltage charging.

At block S40, a current of the battery is acquired, and charging of the battery is stopped when the current of the battery reaches a preset threshold current.

If the third voltage is applied to the battery for constant-voltage charging, a charging voltage of the battery can be adjusted to the third voltage to be applied to the battery of the device to-be-charged for constant-voltage charging. In other words, during constant-voltage charging, the charging voltage can remain constant, and the current of the battery gradually decreases as charging progresses.

As an example, after the voltage across the battery reaches the third voltage through the constant-current charging at blocks S10-S20, a capacity of the battery increases from 0% of the rated capacity to a relatively high capacity, for example, more than 80% (or equal to 80%). When the constant-voltage charging at block S30 is performed on the battery, it is only necessary to fully charge a remaining capacity (that is, less than 20% of the rated capacity) of the battery to complete the remaining charging.

It can be understood that, with the progress of constant-voltage charging, the capacity of the battery increases, a current required for maintaining the third voltage decreases, and when the current of the battery reaches the preset threshold current, charging is stopped. In this situation, the battery can be considered to be fully charged. In other words, when the third voltage is applied to the battery for constant-voltage charging, the charging voltage is maintained at the third voltage. The current of the battery can be acquired in real time, and when the current of the battery reaches the preset threshold current, charging of the battery is stopped.

As such, by applying the third voltage to the battery for constant-voltage charging, it is possible to allow for a large cut-off current, which can shorten charging time and increase charging speed, thereby improving charging efficiency.

It should be understood that, the charging parameters described above (that is, the second charging rate, the third charging rate, the second voltage, the third voltage, and the preset threshold current) can be stored in a charging apparatus or the device to-be-charged, and this depends on whether the method provided herein is performed by the charging apparatus or the device to-be-charged.

For example, when the method is applied to the charging apparatus, the device to-be-charged is responsible for acquiring state parameters of the battery (here, the voltage across the battery and the current of the battery), and sending, via a data line of a charging interface, the voltage across the battery and the current of the battery to the charging apparatus. When coupled with the device to-be-charged via the charging interface, the charging apparatus performs constant-current charging on the battery at the second charging rate (that is, adjusts the charging current to correspond to the second charging rate) and acquires, via the device to-be-charged, the voltage across the battery during constant-current charging. When the voltage across the battery reaches the second voltage, the charging apparatus performs constant-current charging on the battery at the third charging rate (that is, adjusts the charging current to correspond to the third charging rate) and acquires, via the device to-be-charged, the voltage across the battery during constant-current charging. When the voltage across the battery reaches the third voltage, the charging apparatus applies the third voltage to the battery for constant-voltage charging, that is, adjusts the charging voltage to the third voltage. During the constant-voltage charging, the charging apparatus acquires the current of the battery via the device to-be-charged and stops charging when the current of the battery reaches the preset threshold current.

For another example, when the method is applied to the device to-be-charged, the device to-be-charged is not only responsible for acquiring the state parameters of the battery (here, the voltage across the battery and the current of the battery) but also responsible for sending charging parameters (here, the second charging rate, the third charging rate, the second voltage, the third voltage, and the preset threshold current) to the charging apparatus. When coupled with the charging apparatus via the charging interface, the device to-be-charged sends the second charging rate and a constant-current-charging instruction to the charging apparatus. The charging apparatus, upon receiving the second charging rate and the constant-current-charging instruction, performs constant-current charging on the battery at the second charging rate received, that is, adjusts the charging current to correspond to the second charging rate. The device to-be-charged acquires the voltage across the battery during constant-current charging, and when the voltage across the battery reaches the second voltage, sends the third charging rate and a constant-current-charging instruction to the charging apparatus. The charging apparatus, upon receiving the third charging rate and the constant-current-charging instruction, performs constant-current charging on the battery at the third charging rate received, that is, adjusts the charging current to correspond to the third charging rate. The device to-be-charged acquires the voltage across the battery during constant-current charging, and when the voltage across the battery reaches the third voltage, sends information indicating the third voltage and a constant-voltage-charging instruction to the charging apparatus. The charging apparatus applies the third voltage to the battery for constant-voltage charging, that is, adjusts the charging voltage to the third voltage. The device to-be-charged acquires the current of the battery during the constant-voltage charging and stops charging when the current of the battery reaches the preset threshold current.

In connection with examples in FIG 1, when constant-current charging is performed on the battery at the second charging rate, the control unit can adjust the duty cycle of the control signal according to the second charging rate and the output current of the second rectifying unit, such that a current with a third pulsating waveform outputted by the second rectifying unit meets requirements on constant-current charging at the second charging rate. Similarly, when constant-current charging is performed on the battery at the third charging rate, the control unit can adjust the duty cycle of the control signal according to the third charging rate and the output current of the second rectifying unit, such that a current with a third pulsating waveform outputted by the second rectifying unit meets requirements on constant-current charging at the third charging rate. When the third voltage is applied to the battery for constant-voltage charging, the control unit can adjust the duty cycle of the control signal according to the third voltage and the output voltage of the second rectifying unit, such that the voltage with a third pulsating waveform outputted by the second rectifying unit meets requirements on constant-voltage charging with the third voltage.

As such, according to the method provided herein, constant-current charging is first performed on the battery at the second charging rate until the voltage across the battery reaches the second voltage. Then constant-current charging is performed on the battery at the third charging rate until the voltage across the battery reaches the third voltage that is higher than the second voltage. The third voltage is applied to the battery for constant-voltage charging, and when the current of the battery reaches the preset threshold current, charging of the battery is stopped. In this way, the voltage across the battery can exceed the rated voltage through charging, and thus charging can be performed beyond limitation of rated parameters of the battery, which can significantly shorten charging time and increase charging speed while not adversely affecting service life of the battery.

2) The device to-be-charged includes multiple batteries.

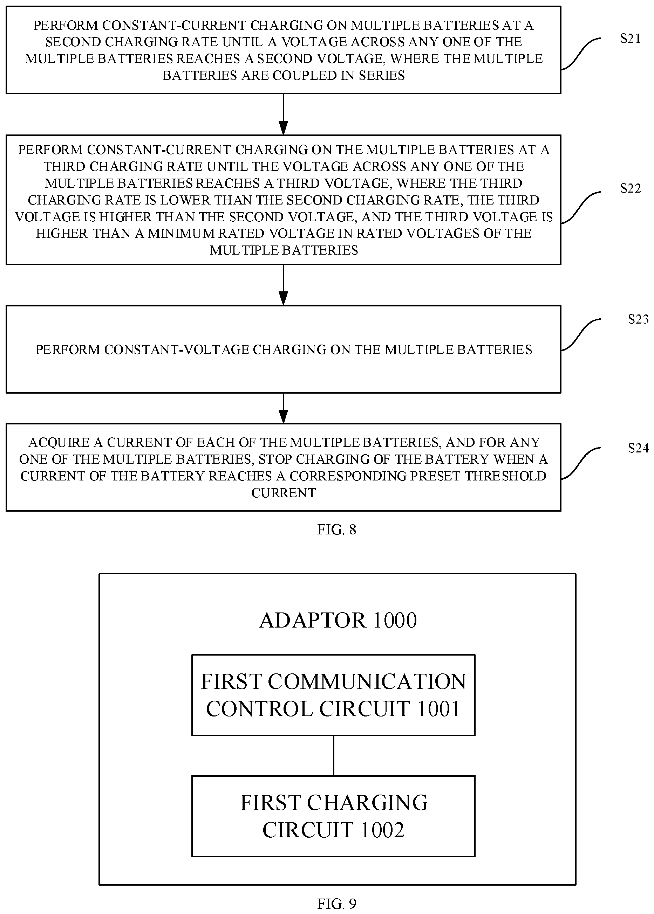

FIG 8 is a flowchart of a method for quick charging of a battery according to other implementations. As illustrated in FIG 8, the method includes the following.

At block S21, constant-current charging is performed on multiple batteries at a second charging rate until a voltage across any one of the multiple batteries reaches a second voltage.

According to implementations, the multiple batteries are coupled in series.

At block S22, constant-current charging is performed on the multiple batteries at a third charging rate until the voltage across any one of the multiple batteries reaches a third voltage, where the third charging rate is lower than the second charging rate, the third voltage is higher than the second voltage, and the third voltage is higher than a minimum rated voltage in rated voltages of the multiple batteries.

The second charging rate and the second voltage can be set in advance. When constant-current charging is performed on the multiple batteries at the second charging rate, a charging current can be adjusted to correspond to the second charging rate for constant-current charging of the multiple batteries of the device to-be-charged. Similarly, the third charging rate and the third voltage can be set in advance. When constant-current charging is performed on the multiple batteries at the third charging rate, the charging current can be adjusted to correspond to the third charging rate for constant-current charging of the multiple batteries of the device to-be-charged. During constant-current charging, the charging current can remain constant, and a voltage across each of the multiple batteries gradually increases as charging progresses.

In addition, during constant-current charging of the multiple batteries, the voltage across each of the multiple batteries can be monitored, and balance control can be performed on the multiple batteries according to the voltage across each of the multiple batteries, such that the voltage across each of the multiple batteries remains almost equal to each other. Therefore, constant-current charging can be performed on the multiple batteries until the voltage across any one of the multiple batteries reaches the second voltage or the third voltage.

In some implementations, the second charging rate is a minimum rated charging rate in rated charging rates of the at least one battery, and the third charging rate is lower than the minimum rated charging rate. It should be understood that, a rated parameter of each of the multiple batteries (such as rated charging rate or rated voltage) may be the same or different. As an example, the rated charging rate of each of the multiple batteries is the same. If the rated charging rate of each of the multiple batteries is 1.5C, the second charging rate can be 1.5C, and the third charging rate can be 1.0C. As another example, the rated charging rate of each of the multiple batteries is different. If a minimum rated charging rate in rated charging rates of the multiple batteries is 1.5C, the second charging rate can be 1.5C, and the third charging rate can be 1.0C.

In some implementations, the second voltage is the minimum rated voltage, and the third voltage is 1.01∼1.2 times the minimum rated voltage. It should be understood that, different batteries may have the same rated voltage or different rated voltages. For example, when each battery has a rated voltage of 4.4V, the third voltage may be 1.01∼1.2 times the rated voltage of 4.4V, such as 4.45V or even higher. For another example, the multiple batteries include two batteries, where a first battery of the two batteries has a rated voltage of 4.4V and a second battery has a rated voltage of 4.2V In this situation, the first voltage may be 4.25V or even higher.

In addition, a rated voltage of each of the at least one battery is lower than (that is, less than) a voltage at which lithium precipitation occurs during charging of the battery. In order to ensure no lithium precipitation during charging, the third voltage is also lower than a voltage at which lithium precipitation occurs during charging of each of the multiple batteries.

It should be noted that, the third voltage can be determined through an experimental test. The third voltage can be determined offline, and the third voltage determined through the test can be directly used during interaction.

It should be understood that, the third voltage can be determined according to the voltage at which lithium precipitation occurs during charging of each of the multiple batteries. For example, in order to determine the third voltage, the voltage at which lithium precipitation occurs during charging of each of the multiple batteries can be first determined. Then a suitable third voltage can be selected according to the voltage at which lithium precipitation occurs during charging of each of the multiple batteries, in order to select the third voltage that is higher than a rated voltage of each of the multiple batteries while ensuring no lithium precipitation during charging. In other words, the third voltage selected can be higher than the rated voltage of each of the multiple batteries. The third voltage can be high enough as long as no lithium precipitation occurs during the whole charging process.

According to implementations herein, constant-current charging is first performed on the multiple batteries at the minimum rated charging rate of the multiple batteries until the voltage across any one of the multiple batteries reaches the minimum rated voltage of the multiple batteries. After the voltage across any one of the multiple batteries reaches the minimum rated voltage, constant-current charging is performed on the multiple batteries at the third charging rate that is lower than the minimum rated charging rate until the voltage across any one of the multiple batteries reaches the third voltage that is higher than the minimum rated voltage. As such, it is possible to further increase charging speed and improve charging efficiency, and on the other hand, the voltage across each of the multiple batteries can be accurately maintained at the third voltage, thereby ensuring no lithium precipitation during the whole charging process.

At block S23, constant-voltage charging is performed on the multiple batteries.

According to implementations, a sum of multiple third voltages is applied to the multiple batteries for constant-voltage charging.

At block S24, a current of each of the multiple batteries is acquired, and for any one of the multiple batteries, charging of the battery is stopped when a current of the battery reaches a corresponding preset threshold current.

As an example, the multiple batteries include *N* batteries, where *N* is an integer greater than one. In this situation, a sum of *N* third voltages *V*₃ (that is, *V*_{*3*×}*N*) can be applied to the *N* batteries for constant-voltage charging. During the constant-voltage charging, the voltage across each of the multiple batteries can be monitored, and balance control can be performed on the multiple batteries according to the voltage across each of the multiple batteries, such that the voltage across each of the multiple batteries remains almost equal to each other.

In addition, the *N* batteries correspond to *N* preset threshold currents respectively. During the constant-voltage charging, a current of each of the *N* batteries can be detected. When a current of an *i^{th}* battery reaches a preset threshold current of the *i^{th}* battery, charging of the *i^{th}* battery is stopped, where 1≤*i*≤*N.* For example, charging of the *i^{th}* battery can be stopped by disconnecting the *i^{th}* battery via a switch.

Furthermore, after charging of the *i^{th}* battery is stopped, the sum of *N* third voltages can be adjusted to a sum of *(N-1)* third voltages to be applied to the *N* batteries for constant-voltage charging, and balance control is performed on the remaining *(N-1)* batteries. At the same time, a current of each of the remaining *(N-1)* batteries is monitored. When a current of a *j^{th}* battery reaches a preset threshold current of the *j^{th}* battery, charging of the *j^{th}* battery is stopped, where *j≠i,* and 1≤*j*≤*N.*

The above steps are thus repeated until the current of each of the *N* batteries reaches the corresponding preset threshold current, and thus the whole charging process is completed.

If the sum of multiple third voltages is applied to the multiple batteries for constant-voltage charging, a charging voltage of the multiple batteries can be adjusted to the sum of multiple third voltages, to be applied to the multiple batteries of the device to-be-charged for constant-voltage charging. In other words, during constant-voltage charging, the charging voltage can remain constant, and the current of each of the multiple batteries gradually decreases as charging progresses.

As an example, after the voltage across any one of the multiple batteries reaches the third voltage through the constant-current charging at block S11, a capacity of any one of the multiple batteries increases from 0% of the rated capacity to a relatively high capacity, for example, more than 80% (or equal to 80%). When the constant-voltage charging at block S21 is performed on the multiple batteries, it is only necessary to fully charge a remaining capacity of each of the multiple batteries to complete the remaining charging.

It can be understood that, with the progress of constant-voltage charging, a capacity of a battery increases, a current required for maintaining the third voltage decreases, and when a current of the battery reaches a preset threshold current, charging is stopped. In this situation, the battery can be considered to be fully charged. In other words, when the sum of multiple third voltages is applied to the multiple batteries for constant-voltage charging, the charging voltage is maintained at the sum of multiple third voltages. The current of each of the multiple batteries can be acquired in real time, and for any one of the multiple batteries, when a current of that battery reaches the corresponding preset threshold current, charging of the battery is stopped.

As such, by applying the sum of multiple third voltages to the multiple batteries for constant-voltage charging, it is possible to allow for a large cut-off current, which can shorten charging time and increase charging speed, thereby improving charging efficiency.

It should be understood that, the charging parameters described above (that is, the second charging rate, the third charging rate, the second voltage, the third voltage, and the preset threshold current) can be stored in a charging apparatus or the device to-be-charged, and this depends on whether the method provided herein is performed by the charging apparatus or the device to-be-charged.

For example, when the method is applied to the charging apparatus, the device to-be-charged is responsible for acquiring state parameters of the battery (here, a voltage across the battery and a current of the battery), and sending, via a data line of a charging interface, the voltage across the battery and the current of the battery to the charging apparatus. When coupled with the device to-be-charged via the charging interface, the charging apparatus performs constant-current charging on the multiple batteries at the second charging rate (that is, adjusts the charging current to correspond to the second charging rate) and acquires, via the device to-be-charged, the voltage across each of the multiple batteries during constant-current charging. When the voltage across any one of the multiple batteries reaches the second voltage, the charging apparatus performs constant-current charging on the multiple batteries at the third charging rate (that is, adjusts the charging current to correspond to the third charging rate) and acquires, via the device to-be-charged, the voltage across each of the multiple batteries during constant-current charging. When the voltage across any one of the multiple batteries reaches the third voltage, the charging apparatus applies the sum of multiple third voltages to the multiple batteries for constant-voltage charging, that is, adjusts the charging voltage to the sum of multiple third voltages. During the constant-voltage charging, the charging apparatus acquires the current of each of the multiple batteries via the device to-be-charged, and for any one of the multiple batteries, stops charging of that battery when the current of the battery reaches the corresponding preset threshold current.

For another example, when the method is applied to the device to-be-charged, the device to-be-charged is not only responsible for acquiring the state parameters of the battery (here, the voltage across the battery and the current of the battery) but also responsible for sending charging parameters (here, the second charging rate, the third charging rate, the second voltage, the third voltage, and the preset threshold current) to the charging apparatus. When coupled with the charging apparatus via the charging interface, the device to-be-charged sends the second charging rate and a constant-current-charging instruction to the charging apparatus. The charging apparatus, upon receiving the second charging rate and the constant-current-charging instruction, performs constant-current charging on the multiple batteries at the second charging rate received, that is, adjusts the charging current to correspond to the second charging rate. The device to-be-charged acquires the voltage across each of the multiple batteries during constant-current charging, and when the voltage across any one of the multiple batteries reaches the second voltage, sends the third charging rate and a constant-current-charging instruction to the charging apparatus. The charging apparatus, upon receiving the third charging rate and the constant-current-charging instruction, performs constant-current charging on the multiple batteries at the third charging rate received, that is, adjusts the charging current to correspond to the third charging rate. The device to-be-charged acquires the voltage across each of the multiple batteries during constant-current charging, and when the voltage across any one of the multiple batteries reaches the third voltage, sends information indicating the third voltage and a constant-voltage-charging instruction to the charging apparatus. The charging apparatus applies the sum of multiple third voltages to the multiple batteries for constant-voltage charging, that is, adjusts the charging voltage to the sum of multiple third voltages. The device to-be-charged acquires the current of each of the multiple batteries during the constant-voltage charging, and for any one of the multiple batteries, stops charging of that battery when the current of the battery reaches the corresponding preset threshold current.

In connection with examples in FIG 1, when constant-current charging is performed on the battery at the first charging rate, the control unit can adjust the duty cycle of the control signal according to the first charging rate and the output current of the second rectifying unit, such that a current with a third pulsating waveform outputted by the second rectifying unit meets requirements on constant-current charging at the first charging rate. When the sum of multiple third voltages is applied to the multiple batteries for constant-voltage charging, the control unit can adjust the duty cycle of the control signal according to the sum of multiple third voltages and the output voltage of the second rectifying unit, such that the voltage with a third pulsating waveform outputted by the second rectifying unit meets requirements on constant-voltage charging with the sum of multiple third voltages.

As such, according to the method provided herein, constant-current charging is first performed on the multiple batteries at the second charging rate until the voltage across any one of the multiple batteries reaches the second voltage. Then constant-current charging is performed on multiple batteries at the third charging rate until the voltage across any one of the multiple batteries reaches the third voltage that is higher than the second voltage. The third voltage is applied to the multiple batteries for constant-voltage charging, and for any one of the multiple batteries, when the current of that battery reaches the corresponding preset threshold current, charging of the battery is stopped. In this way, the battery can be charged until the voltage across the battery exceeds the rated voltage, and thus charging can be performed beyond limitation of rated parameters of the battery, which can significantly shorten charging time and increase charging speed without adversely affecting service life of the battery.

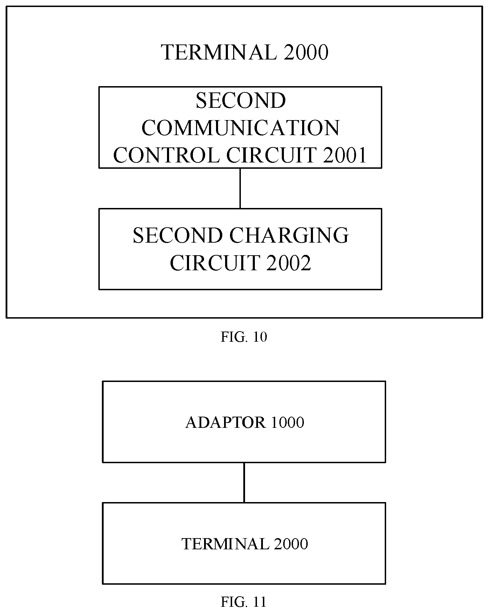

The following will describe in detail a charging apparatus and a device to-be-charged according to implementations with reference to FIG 9 and FIG 10. It should be noted that, the foregoing description of the implementations of the method for quick charging of a battery is also applicable to the charging apparatus and the device to-be-charged, which will not be repeated herein.

FIG 9 is a schematic block diagram of a charging apparatus according to other implementations. The charging apparatus is configured to communicate with a device to-be-charged when coupled with the device to-be-charged via a charging interface. As illustrated in FIG 9, the charging apparatus 1000 includes a first communication control circuit 1001 and a first charging circuit 1002.

The first communication control circuit 1001 is configured to operate as follows. The first communication control circuit 1001 is configured to perform, via the first charging circuit 1002, constant-current charging on at least one battery at a second charging rate until a voltage across any one of the at least one battery reaches a second voltage. The first communication control circuit 1001 is configured to perform, via the first charging circuit 1002, constant-current charging on the at least one battery at a third charging rate until the voltage across any one of the at least one battery reaches a third voltage, where the first communication control circuit is configured to acquire a voltage across each of the at least one battery via the device to-be-charged, the third charging rate is lower than the second charging rate, the third voltage is higher than the second voltage, and the third voltage is higher than a minimum rated voltage in rated voltages of the at least one battery. The first communication control circuit 1001 is configured to perform, via the first charging circuit 1002, constant-voltage charging on the at least one battery, acquire, via the device to-be-charged, a current of each of the at least one battery, and for any one of the at least one battery, stop charging of the battery performed via the first charging circuit 1002 when a current of the battery reaches a corresponding preset threshold current.

According to implementations, the at least one battery is coupled in series. The first communication control circuit 1001 is configured to apply, via the first charging circuit 1002, a sum of at least one third voltage to the at least one battery for constant-voltage charging.

It should be understood that, for the device to-be-charged provided herein, the division of units is only a division of logical functions, and there may exist other manners of division in practice. For example, in connection with the charging apparatus illustrated in in FIG 1, the first charging circuit 1002 can include the first rectifying unit 101, the switch unit 102, the transformer 103, the second rectifying unit 104, and a power line of the first charging interface 105. The first communication control circuit 1001 can include the sampling unit 106, the control unit 107, and a communication line of the first charging interface 105.

In some examples, the second charging rate is a minimum rated charging rate in rated charging rates of the at least one battery, and the third charging rate is lower than the minimum rated charging rate.

In some examples, the second voltage is the minimum rated voltage, and the third voltage is 1.01∼1.2 times the minimum rated voltage.

In some examples, a rated voltage of each of the at least one battery is lower than a voltage at which lithium precipitation occurs during charging of the battery.

In this way, a battery can be charged until a voltage across the battery reaches a voltage that exceeds a rated voltage, thus achieving charging beyond limitation of rated parameters of the battery, which is possible to significantly shorten charging time and increase charging speed while not adversely affecting service life of the battery.

FIG 10 is a schematic block diagram of a device to-be-charged according to other implementations. The device to-be-charged is configured to communicate with a charging apparatus when coupled with the charging apparatus via a charging interface. As illustrated in FIG 10, the device to-be-charged 2000 includes a second communication control circuit 2001 and a second charging circuit 2002.

The second communication control circuit 2001 is configured to operate as follows. The second communication control circuit 2001 is configured to send a second charging rate to the charging apparatus, such that the charging apparatus performs, via the second charging circuit 2002, constant-current charging on at least one battery at the second charging rate until a voltage across any one of the at least one battery reaches a second voltage. The second communication control circuit 2001 is configured to send a third charging rate to the charging apparatus, such that the charging apparatus performs, via the second charging circuit 2002, constant-current charging on the at least one battery at the third charging rate until the voltage across any one of the at least one battery reaches a third voltage, where the third charging rate is lower than the second charging rate, the third voltage is higher than the second voltage, and the third voltage is higher than a minimum rated voltage in rated voltages of the at least one battery. The second communication control circuit 2001 is configured to send a constant-voltage-charging instruction to the charging apparatus, such that the charging apparatus performs, via the second charging circuit 2002, constant-voltage charging on the at least one battery, acquires a current of each of the at least one battery, and for any one of the at least one battery, stops charging of any one of the battery when a current of the battery reaches a corresponding preset threshold current.

According to implementations, the at least one battery is coupled in series. The second communication control circuit 2001 is configured to send a sum of at least one third voltage and the constant-voltage-charging instruction to the charging apparatus, such that the charging apparatus applies, via the second charging circuit 2002, the sum of at least one third voltage to the at least one battery for constant-voltage charging.

It should be understood that, for the device to-be-charged provided herein, the division of units is only a division of logical functions, and there may exist other manners of division in practice. For example, in connection with the charging apparatus illustrated in FIG 1, the second charging circuit 2002 can include a power line of the second charging interface 201 and a charging circuit disposed between the second charging interface 201 and the battery 202. The second communication control circuit 2001 can include a communication line of the second charging interface 201 and a control unit that is coupled with the communication line and configured to control charging of the at least one battery performed by the charging apparatus.

In some examples, the second charging rate is a minimum rated charging rate in rated charging rates of the at least one battery, and the third charging rate is lower than the minimum rated charging rate.

In some examples, the second voltage is the minimum rated voltage, and the third voltage is 1.01∼1.2 times the minimum rated voltage.

In some examples, a rated voltage of each of the at least one battery is lower than a voltage at which lithium precipitation occurs during charging of the battery.

In this way, a voltage across a battery can exceed a rated voltage through charging, which is possible to charge the battery beyond limitation of rated parameters of the battery. As such, charging time can be significantly shortened and charging speed can be increased without adversely affecting service life of the battery.

FIG 11 is a schematic block diagram of a charging system according to other implementations. The charging system 3000 illustrated in FIG 11 includes the charging apparatus 1000 illustrated in FIG 9 and the device to-be-charged 2000 illustrated in FIG 10.

In this way, a battery can be charged until a voltage that exceeds a rated voltage is reached, which can achieve charging beyond limitation of rated parameters of the battery. As such, charging time can be significantly shortened and charging speed can be increased without adversely affecting service life of the battery.

To achieve the above implementations, a non-transitory computer-readable storage medium is further provided. The non-transitory computer-readable storage medium is configured to store programs for quick charging of a battery which, when executed by a processor, are operable with the processor to perform the method for quick charging of a battery described in the foregoing implementations.

It will be appreciated that the systems, apparatuses, and methods disclosed in implementations herein may also be implemented in various other manners. For example, the above apparatus implementations are merely illustrative, e.g., the division of units is only a division of logical functions, and there may exist other manners of division in practice, e.g., multiple units or assemblies may be combined or may be integrated into another system, or some features may be ignored or skipped. In other respects, the coupling or direct coupling or communication connection as illustrated or discussed may be an indirect coupling or communication connection through some interface, device or unit, and may be electrical, mechanical, or otherwise.

Separated units as illustrated may or may not be physically separated. Components or parts displayed as units may or may not be physical units, and may reside at one location or may be distributed to multiple networked units. Some or all of the units may be selectively adopted according to practical needs to achieve desired objectives of the disclosure.

Various functional units described in implementations herein may be integrated into one processing unit or may be present as a number of physically separated units, and two or more units may be integrated into one

If the functions are implemented as software functional units and sold or used as standalone products, they may be stored in a computer readable storage medium. Based on such an understanding, the essential technical solution, or the portion that contributes to the prior art, or part of the technical solution of the disclosure may be embodied as software products. The computer software products can be stored in a storage medium and may include multiple instructions that, when executed, can cause a computing device, e.g., a personal computer, a server, a network device, etc, to execute some or all operations of the methods described in various implementations. The above storage medium may include various kinds of media that can store program codes, such as a universal serial bus (USB) flash disk, a mobile hard drive, a read only memory (ROM), a random access memory (RAM), a magnetic disk, or an optical disk.

While the disclosure has been described in connection with certain embodiments, it is to be understood that the disclosure is not to be limited to the disclosed embodiments but, on the contrary, is intended to cover various modifications and equivalent arrangements included within the scope of the appended claims, which scope is to be accorded the broadest interpretation so as to encompass all such modifications and equivalent structures as is permitted under the law.

## Claims

1. A method for quick charging of a battery, comprising:
performing constant-current charging on at least one battery at a first charging rate until a voltage across any one of the at least one battery reaches a first voltage, wherein the first voltage is higher than a minimum rated voltage in rated voltages of the at least one battery;
performing constant-voltage charging on the at least one battery; and
acquiring a current of each of the at least one battery, and for any one of the at least one battery, stopping charging of the battery when a current of the battery reaches a corresponding preset threshold current.

2. The method of claim 1, wherein the at least one battery comprises two or more than two batteries coupled in series, and the first charging rate is lower than or equal to a rated charging rate of each of the at least one battery.

3. The method of claim 1 or 2, wherein the first voltage is 1.01∼1.2 times the minimum rated voltage.

4. The method of any one of claims 1 to 3, wherein a rated voltage of each of the at least one battery is lower than a voltage at which lithium precipitation occurs during charging of the battery.

5. A charging apparatus, configured to communicate with a device to-be-charged when coupled with the device to-be-charged via a charging interface and comprising:
a first charging circuit; and
a first communication control circuit configured to
perform, via the first charging circuit, constant-current charging on at least one battery at a first charging rate until a voltage across any one of the at least one battery reaches a first voltage, and acquire, via the device to-be-charged, a voltage across each of the at least one battery, wherein the first voltage is higher than a minimum rated voltage in rated voltages of the at least one battery; and
perform, via the first charging circuit, constant-voltage charging on the at least one battery, acquire, via the device to-be-charged, a current of each of the at least one battery, and for any one of the at least one battery, stop charging of the battery when a current of the battery reaches a corresponding preset threshold current.

6. The charging apparatus of claim 5, wherein the at least one battery comprises two or more than two batteries coupled in series, and the first charging rate is lower than or equal to a rated charging rate of each of the at least one battery.

7. The charging apparatus of claim 5 or 6, wherein the first voltage is 1.01∼1.2 times the minimum rated voltage, and a rated voltage of each of the at least one battery is lower than a voltage at which lithium precipitation occurs during charging of the battery.

8. A device to-be-charged, configured to communicate with a charging apparatus when coupled with the charging apparatus via a charging interface and comprising:
a second charging circuit; and
a second communication control circuit configured to
send a first charging rate to the charging apparatus, such that the charging apparatus performs, via the second charging circuit, constant-current charging on at least one battery at the first charging rate until a voltage across any one of the at least one battery reaches a first voltage, wherein the first voltage is higher than a minimum rated voltage in rated voltages of the at least one battery; and
send a constant-voltage-charging instruction to the charging apparatus, such that the charging apparatus performs, via the second charging circuit, constant-voltage charging on the at least one battery, acquires a current of each of the at least one battery, and for any one of the at least one battery, stops charging of the battery when a current of the battery reaches a corresponding preset threshold current.

9. The device to-be-charged of claim 8, wherein the at least one battery comprises two or more than two batteries coupled in series, and the first charging rate is lower than or equal to a rated charging rate of each of the at least one battery.

10. The device to-be-charged of claim 8 or 9, wherein the first voltage is 1.01∼1.2 times the minimum rated voltage, and a rated voltage of each of the at least one battery is lower than a voltage at which lithium precipitation occurs during charging of the battery.

11. A charging system, comprising the charging apparatus of any of claims 5 to 8 and the device to-be-charged of any of claims 8 to 10.

12. A non-transitory computer-readable storage medium configured to store programs for quick charging of a battery which, when executed by a processor, are operable with the processor to perform the method for quick charging of a battery of any of claims 1 to 4.

13. A method for quick charging of a battery, comprising:
performing constant-current charging on at least one battery at a second charging rate until a voltage across any one of the at least one battery reaches a second voltage;
performing constant-current charging on the at least one battery at a third charging rate until the voltage across any one of the at least one battery reaches a third voltage, wherein the third charging rate is lower than the second charging rate, the third voltage is higher than the second voltage, and the third voltage is higher than a minimum rated voltage in rated voltages of the at least one battery;
performing constant-voltage charging on the at least one battery; and
acquiring a current of each of the at least one battery, and for any one of the at least one battery, stopping charging of the battery when a current of the battery reaches a corresponding preset threshold current.

14. The method of claim 13, wherein the least one battery comprises two or more than two batteries coupled in series, the second charging rate is a minimum rated charging rate in rated charging rates of the at least one battery, and the third charging rate is lower than the minimum rated charging rate.

15. The method of claim 13 or 14, wherein the second voltage is the minimum rated voltage, and the third voltage is 1.01∼1.2 times the minimum rated voltage.

16. The method of claim 15, wherein a rated voltage of each of the at least one battery is lower than a voltage at which lithium precipitation occurs during charging of the battery.

17. A charging apparatus, configured to communicate with a device to-be-charged when coupled with the device to-be-charged via a charging interface and comprising:
a first charging circuit; and
a first communication control circuit configured to:
perform, via the first charging circuit, constant-current charging on at least one battery at a second charging rate until a voltage across any one of the at least one battery reaches a second voltage;
perform, via the first charging circuit, constant-current charging on the at least one battery at a third charging rate until the voltage across any one of the at least one battery reaches a third voltage, wherein the first communication control circuit is configured to acquire a voltage across each of the at least one battery via the device to-be-charged, the third charging rate is lower than the second charging rate, the third voltage is higher than the second voltage, and the third voltage is higher than a minimum rated voltage in rated voltages of the at least one battery; and
perform, via the first charging circuit, constant-voltage charging on the at least one battery, acquire, via the device to-be-charged, a current of each of the at least one battery, and for any one of the at least one battery, stop charging of the battery performed via the first charging circuit when a current of the battery reaches a corresponding preset threshold current.

18. A device to-be-charged, configured to communicate with a charging apparatus when coupled with the charging apparatus via a charging interface and comprising:
a second charging circuit; and
a second communication control circuit configured to:
send a second charging rate to the charging apparatus, such that the charging apparatus performs, via the second charging circuit, constant-current charging on at least one battery at the second charging rate until a voltage across any one of the at least one battery reaches a second voltage;
send a third charging rate to the charging apparatus, such that the charging apparatus performs, via the second charging circuit, constant-current charging on the at least one battery at the third charging rate until the voltage across any one of the at least one battery reaches a third voltage, wherein the third charging rate is lower than the second charging rate, the third voltage is higher than the second voltage, and the third voltage is higher than a minimum rated voltage in rated voltages of the at least one battery; and
send a constant-voltage-charging instruction to the charging apparatus, such that the charging apparatus performs, via the second charging circuit, constant-voltage charging on the at least one battery, acquires a current of each of the at least one battery, and for any one of the at least one battery, stops charging of the battery when a current of the battery reaches a corresponding preset threshold current.

19. A charging system, comprising the charging apparatus of claim 17 and the device to-be-charged of claim 18.

20. A non-transitory computer-readable storage medium configured to store programs for quick charging of a battery which, when executed by a processor, are operable with the processor to perform the method for quick charging of a battery of any of claims 13 to 16.
